# EUROPEAN PATENT APPLICATION

(11) **EP 2 341 643 A1**
(43) Date of publication of application: **06.07.2011**
(21) Application number: 09812643.6
(22) Date of filing: 02.09.2009
(51) Int. Cl.: H04B 10/18

(54) **METHOD AND APPARATUS FOR FILTER LOCKING**

(30) Priority: 09.09.2008 CN 200810211900
(71) Applicant: Huawei Technologies Co., Ltd., Longgang District, Shenzhen Guangdong 518129 (CN)
(72) Inventor: TANG, Fei, Shenzhen Guangdong 518129 (CN); WU, Shuangqi, Shenzhen Guangdong 518129 (CN); ZHANG, Hongping, Shenzhen Guangdong 518129 (CN)
(74) Representative: Kreuz, Georg Maria
(86) International application number: PCT/CN2009/073691
(87) International publication number: WO 2010/028577

(57) **Abstract**

In the field of photonic integrated communication, a method and an apparatus for filtering locking are provided, so as to solve the problem in the conventional wavelength locking technology that any increase of the wave number also incurs increases in costs and circuit complexity, and it is difficult to extract dithered information. The method and apparatus for filtering locking employ a centralized wavelength locking method of injecting a single dither to a Photonic Integrated Device (PID)/Photonic Integrated Circuit (PIC), thereby reducing circuit board area and control circuit complexity. A weak dither signal can be accurately extracted by means of a combination of analog filtering and digital filtering. The technical solution is appropriate for use in photonic integrated systems in which two or more PID/PIC chips with multi-wavelength modules are cascaded.

## Description

### FIELD OF THE INVENTION

The present invention relates to the field of photonic integrated communication, and in particular, to a method and an apparatus for filtering locking in a Photonic Integrated Device (PID)/Photonic Integrated Circuit (PIC).

### BACKGROUND OF THE INVENTION

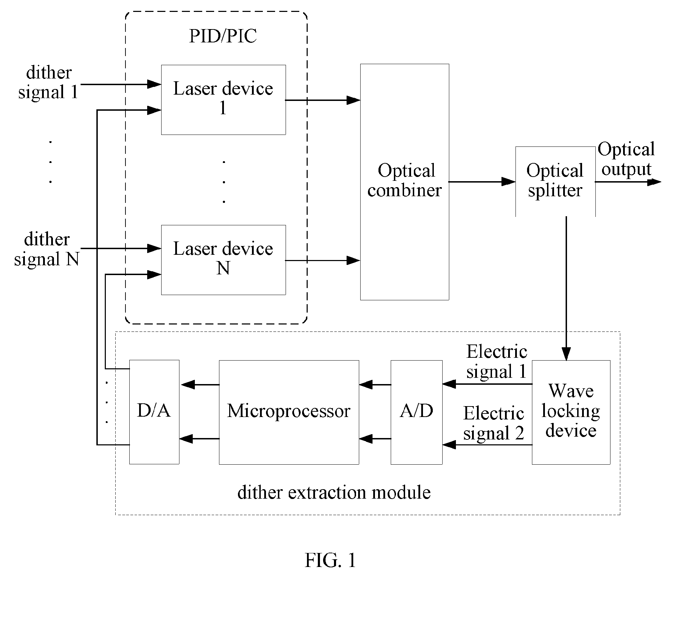

With the development of optical communication services, the integration density of optical devices becomes increasingly higher. For example, as shown in FIG. 1, a PID/PIC includes a laser device array. The laser device array integrates at least two laser devices.

The PID/PIC is connected with an optical combiner. The optical combiner receives lasers emitted by all the laser devices, and combines the received lasers into one optical signal.

The optical combiner is connected with an optical splitter, and the optical signal is transmitted through the optical splitter. During the transmission of the lasers from the laser devices to the optical splitter, the wavelength of the lasers changes with temperature. To distinguish the wavelength currently controlled and locked, the optical splitter is connected with a dither extraction module, and the dither extraction module is connected with the laser device array. The optical splitter extracts a proportion of the optical signal from the optical signal; a wavelength drift of the optical wave is obtained through the dither extraction module, and a dither signal and the wavelength drift of the optical wave are returned to the laser device. The laser device adjusts the wavelength of the emitted optical wave according to the received wavelength drift of the optical wave, and uses the dither signal to mark the adjusted optical wave.

The dither extraction module includes a wave locking device, in which one end of the wave locking device is connected with the optical splitter, and the other end is connected with an analog/digital (A/D) converter; the A/D converter is connected with a microprocessor; the microprocessor is connected with a digital/analog (D/A) converter; and the D/A converter is connected with the laser device.

The wave locking device obtains an analog signal from the extracted optical signal; a digital signal is obtained from the analog signal through the A/D converter, and a dither signal of each wave is obtained through Fast Fourier Transform (FFT) performed by the microprocessor; the digital dither signal is converted to an analog dither signal through the D/A converter, and the analog dither signal is returned to the laser device. A unique dither signal is added to each optical wave to complete the marking of the wavelength.

However, adding the dither, implies that, since one unique dither signal is added to each wave, hardware and software resources need to be multiplied as the wave number increases, thus incurring the problem of costs and circuit complexity. Furthermore, since the response of the wave locking device is small, the obtained dither signal is weak; therefore it is difficult to extract an effective dither signal when the microprocessor at the back end performs frequency-domain FFT transform after directly entering the A/D converter for sampling, and with the increase of the wave number, this disadvantage becomes more obvious. Furthermore, for the application of the PID and PIC with multiple laser device arrays, such a wavelength locking method leads to a complex control circuit and an oversize circuit board, which is against the original aim of saving the size, cost and power consumption by using the PID and PIC.

### SUMMARY OF THE INVENTION

To solve the problem in the prior art that the cost and circuit complexity are increased and it is difficult to extract an effective dither signal since one unique dither signal is added to each wave, the present invention adopts the following technical solutions.

According to the first aspect of the present invention a method for filtering locking includes:
receiving two or more optical waves to which a first dither signal is added by means of time division multiplexing, in which in a predetermined time period, the first dither signal is on one of the two or more optical waves;
combining the two or more optical waves into one optical signal and sending the optical signal;
obtaining a wavelength drift of the optical wave from the optical signal according to the first dither signal; and
performing wavelength locking on the optical wave according to the wavelength drift of the optical wave.

According to the second aspect of the present invention an apparatus for filtering locking includes:
two or more laser devices, adapted to receive two or more optical waves to which a first dither signal is added by means of time division multiplexing, in which in a predetermined time period, the first dither signal is on one of the two or more optical waves;
an optical combiner, adapted to combine the two or more optical waves emitted by the two or more laser devices into one optical signal, and send the optical signal;
a wavelength drift obtaining module, adapted to obtain a wavelength drift of the optical wave from the optical signal according to the first dither signal; and
a wavelength locking module, adapted to perform wavelength locking on the optical wave according to the wavelength drift of the optical wave.

The present invention employs a centralized wavelength locking method of injecting a single dither to a PID/PIC, thereby reducing circuit board area and control circuit complexity; a weak dither signal can be accurately extracted by means of a combination of analog filtering and digital filtering; when the frequency of the dither signal changes, a digital filter only needs to adjust a corresponding parameter to complete the extraction of the dither signal, which achieves high portability and upgradeability. As for a cascade of multiple PIC/PID chips with multi-wavelength modules, the method may be employed with a shared apparatus for filtering locking to perform the wavelength locking on two or more optical waves by means of time division multiplexing.

### BRIEF DESCRIPTION OF THE DRAWINGS

FIG. 1 is a block diagram of a system for wavelength locking in the prior art;
FIG. 2 is a block diagram of a system for locking two or more wavelengths according to an embodiment of the present invention;
FIG. 3 is a block diagram of a system for locking two or more wavelengths in a combination of two or more PIDs/PICs according to an embodiment of the present invention;
FIG. 4 is a flow chart of a method for filtering locking according to an embodiment of the present invention; and
FIG. 5 is a block diagram of an apparatus for filtering locking according to an embodiment of the present invention.

### DETAILED DESCRIPTION OF THE EMBODIMENTS

To solve the problem in the prior art that the cost and circuit complexity are increased and it is difficult to extract an effective dither signal since one unique dither signal is added to each wave, an embodiment of the present invention provides a method for filtering locking.

In a PID/PIC, two or more laser devices exist; each laser device emits a laser; the wavelengths of optical waves emitted by different laser devices are different; the two or more laser devices emit two or more optical waves of different wavelengths, and an optical combiner combines the two or more optical waves into one beam of light and sends the beam.

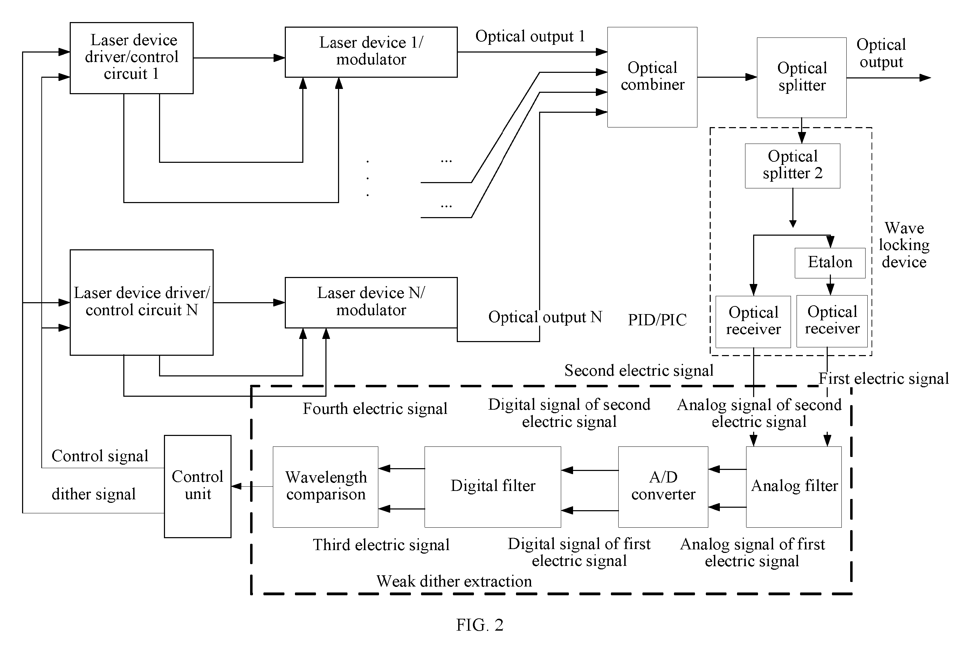

FIG. 2 is a block diagram of a system for locking two or more wavelengths according to an embodiment of the present invention. Referring to FIG. 2, a control unit includes a dither signal generating apparatus for generating a dither signal and sending the dither signal to a laser device in two or more laser device driver/control circuits at the same moment; then, the laser device generates two or more optical waves, the optical combiner combines the two or more optical waves into one optical signal and sends the optical signal; an optical splitter extracts a proportion of the optical signal from the optical signal sent from the optical combiner, and inputs the proportion of the optical signal to a wave locking device. The wave locking device receives the optical signal output from the optical splitter, and splits the optical signal into two optical signals through an optical splitter 2 therein, in which, since an optical receiver is a device sensitive to the optical intensity and capable of converting the optical signal into an electric signal, and an etalon is a device sensitive to the optical wavelength, one optical signal passing through the etalon and the optical receiver becomes the electric signal processed by wavelength and optical intensity processing, and the other optical signal passing through the optical receiver becomes the electric signal processed by optical intensity processing, so as to facilitate a wavelength comparison module to subsequently compare the change of the corresponding wavelength. The two processed electric signals are input to a weak dither extraction module; a wavelength drift of the optical wave to which a dither signal is added is obtained from the weak dither extraction module; then, the control unit adjusts the wavelength of the corresponding optical wave emitted by the laser device according to the wavelength drift.

In the block diagram of the system for locking two or more wavelengths in the prior art shown in FIG. 1, N dither signals exist corresponding to N laser devices, while in the embodiment of the present invention, only one dither signal exists, and in a predetermined time period, the dither signal is added into only one laser device. In addition, in the embodiment of the present invention, the weak dithered extraction module employs a combination of digital filtering and analog filtering; an analog filter includes a small signal amplification unit capable of amplifying weak information output by the wave locking device, so as to facilitate extraction of the dither signal.

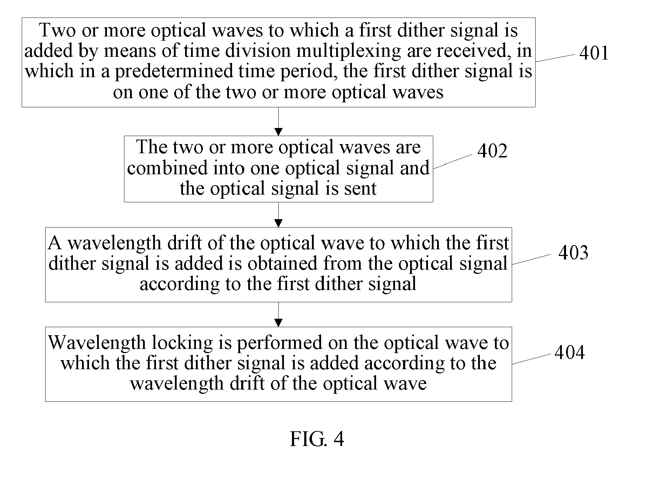

Corresponding to the block diagram of the system for locking two or more wavelengths shown in FIG. 2, an embodiment of the present invention provides a method for filtering locking. As shown in FIG. 4, the method for filtering locking includes the following steps.

In Step 401, two or more optical waves to which a first dither signal is added by means of time division multiplexing are received, in which in a predetermined time period, the first dither signal is on one of the two or more optical waves.

A control unit includes a dither signal generating apparatus capable of generating the dither signal. The control unit sends a first dither signal to two or more laser device driver/control circuits by means of time division multiplexing, in which in a predetermined time period, the first dither signal is added to one of the two or more laser device driver/control circuits. After receiving the first dither signal, the two or more laser device driver/control circuits send two or more electric signals, in which one electric signal is the electric signal to which the first dither signal is added. After receiving the corresponding electric signals (in which the first dither signal is added to one of the electric signals), at least two corresponding laser devices/modulators respectively convert the electric signals into corresponding optical waves, and send the optical waves. The time division multiplexing is that the control unit adds only the first dither signal in a predetermined time period to mark the optical wave emitted by one of the laser devices, the optical waves emitted by other laser devices in the predetermined time period are not marked by the first dither signal, and in a next predetermined time period, a dither signal is added to the optical wave emitted by another laser device for marking the optical wave.

In Step 402, the two or more optical waves are combined into one optical signal and the optical signal is sent.

An optical combiner combines the two or more optical waves emitted by the two or more laser devices into one optical signal, and sends the optical signal.

In Step 403, a wavelength drift of the optical wave to which the first dither signal is added is obtained from the optical signal according to the first dither signal.

The optical splitter extracts a proportion of the optical signal from the optical signal output from the optical combiner according to the first dither signal, and inputs the proportion of the optical signal to a wave locking device. The first dither signal is added to only one of the optical waves contained in the optical signal.

The wave locking device receives the optical signal output from the optical splitter, and divides the optical signal into two through the optical splitter 2, a first electric signal is obtained from one optical signal passing through the etalon in the wave locking device, and a second electric signal is obtained from the other optical signal not passing through the etalon. The etalon is a device sensitive to the optical wavelength, and the wavelength in the first electric signal is processed after passing through the etalon, so as to facilitate a weak dither extraction unit to subsequently compare the first electric signal and the second electric signal to obtain the change of the optical signal.

Weak dither extraction is performed on the first electric signal and the second electric signal to obtain the wavelength drift of the optical wave to which the first dither signal is added, which specifically includes Steps A, B, C and D.

In Step A, an analog filter performs amplification and analog filtering processing on the first electric signal and the second electric signal to respectively obtain an analog signal of the first electric signal and an analog signal of the second electric signal. The analog filter includes a small signal amplification unit, and may amplify weak information output by the wave locking device, so as to facilitate extraction of the dither signal, and then, perform analog filtering processing to eliminate out-of-band noise, so as to obtain the analog signal of the first electric signal and the analog signal of the second electric signal.

In Step B, an A/D converter performs A/D conversion on the analog signal of the first electric signal and the analog signal of the second electric signal to respectively obtain a digital signal of the first electric signal and a digital signal of the second electric signal.

In Step C, a digital filter performs digital filtering on the digital signal of the first electric signal and the digital signal of the second electric signal to respectively obtain a third electric signal containing dither signal information and a fourth electric signal. The digital filter may be realized through programming by a programmable device, and the programmable device includes a Field Programmable Gate Array (FPGA), an Application Specific Integrated Circuit (ASIC), a Central Processing Unit (CPU), and a Digital Signal Processing (DSP). The digital filter may be selected from a finite impulse response filter, an infinite impulse response filter, and a combination thereof. An order of the digital filter may be adjusted through relevant parameters. When the dither signal changes, only a corresponding parameter of the digital filter needs to be changed; when the slope of an edge of a filter window needs to be increased, only the order of the digital filter needs to be added. And a commissioning process thereof may be performed through a Joint Test Action Group (JTAG) or other interfaces of a used specific programming device.

In Step D, the third electric signal and the fourth electric signal are compared with each other, so that the wavelength drift of the optical wave emitted by the laser device to which the first dither signal is added can be obtained according to a comparison result.

In Step 404, wavelength locking is performed on the optical wave to which the first dither signal is added according to the wavelength drift of the optical wave.

The control unit generates a corresponding control signal according to the wavelength drift of the optical wave, and transmits the control signal to the laser device driver/control circuit corresponding to the electric signal to which the first dither signal is added. In addition, the control unit continuously generates new dither signals. In the embodiment of the present invention, a dither signal generated by the control unit in a time period after the generation of the first dither signal is called a second dither signal, and the control unit transmits the second dither signal to the laser device driver/control circuit other than the laser device driver/control circuit corresponding to the optical wave to which the first dither signal is added.

The corresponding laser device driver/control circuits respectively receive the second dither signal and the control signal sent by the control unit. The laser device driver/control circuit corresponding to the optical wave to which the first dither signal is added adjusts the wavelength of the optical wave emitted by the corresponding laser device according to the control signal sent by the control unit, so as to complete the wavelength locking; the laser device driver/control circuit corresponding to the optical wave to which the second dither signal is added adds the second dither signal to the optical wave emitted by the corresponding laser device, and marks the locked optical wave. In one time period, the wavelength locking is performed on the optical wave emitted by one of the two or more laser devices; in a next time period, the wavelength locking is performed on the optical wave emitted by another laser device other than the laser device, and so on. Except for the generation time, other parameters of the first dither signal and the second dither signal are basically the same. The purpose of adding the dither signal to the optical wave is to mark the current optical wave and distinguish the optical wave currently under control; in addition, the wavelength drift of the optical wave is obtained through observing the change of the dither signal, and thereby the wavelength of the optical wave is adjusted, thus completing the wavelength locking.

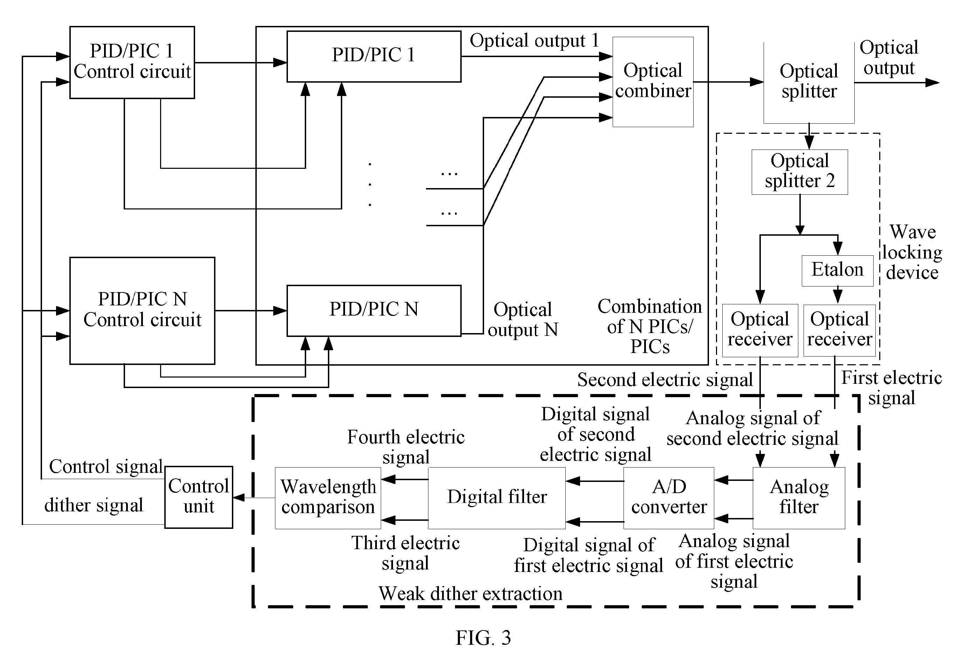

As for a combination of two or more PIDs/PICs, the wavelength locking may be performed by using the above centralized wave locking and dither extraction method. As shown in FIG. 3, N PID/PIC devices are combined, and each PID/PIC includes M laser devices. In one time period, the control unit adds the dither signal to the optical wave emitted by the laser device corresponding to one of the laser device driver/control circuits; each PID/PIC outputs M optical waves; the optical combiner combines the M*N optical waves into one optical signal and sends the optical signal. Through the above method, the wavelength drift of the optical wave to which the dither signal is added can be obtained from the optical wave sent from the optical combiner, thus performing the wavelength locking on the optical wave to which the dither signal is added. In this manner, the wavelength locking of M*N optical waves by using one dither signal can be realized by means of time division multiplexing.

The embodiment of the present invention employs a centralized wavelength locking method of injecting a single dither to a PID/PIC, thereby reducing circuit board area and control circuit complexity; a weak dither signal can be accurately extracted by means of a combination of analog filtering and digital filtering; when the frequency of the dither signal changes, a digital filter only needs to adjust a corresponding parameter to complete the extraction of the dither signal, which achieves high portability and upgradeability. As for a cascade of multiple PIC/PID chips with multi-wavelength modules, the method may be employed with a shared apparatus for filtering locking to perform the wavelength locking on two or more optical waves by means of time division multiplexing.

Corresponding to the system shown in FIG. 2, an embodiment of the present invention further provides an apparatus for filtering locking, which will be described in the following.

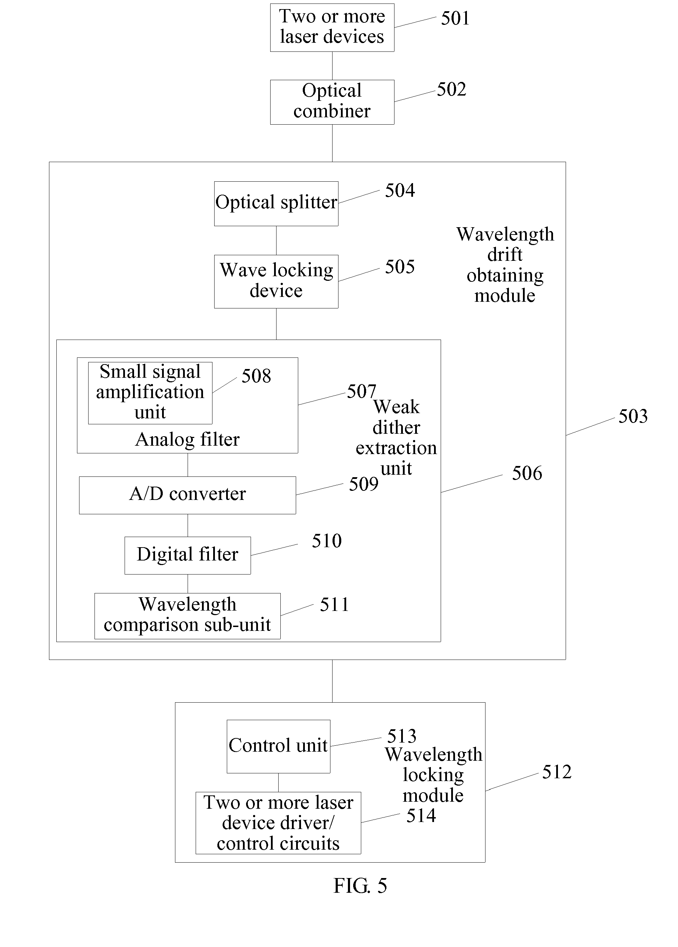

As shown in FIG. 5, the apparatus for filtering locking includes two or more laser devices 501, an optical combiner 502, a wavelength drift obtaining module 503 and a wavelength locking module 512.

The two or more laser devices 501 are adapted to receive two or more optical waves to which a first dither signal is added by means of time division multiplexing, in which in a predetermined time period, the first dither signal is on one of the two or more optical waves.

Each laser device emits one optical wave, and the wavelength of the optical wave emitted by each laser device is different. In the predetermined time period, the two or more laser devices receive two or more electric signals, in which one of the two or more laser devices receives the first dither signal sent by means of time division multiplexing and for marking the optical wave emitted by the laser device; the two or more laser devices convert the received electric signals into corresponding optical waves, and correspondingly, only the optical wave emitted by the laser device contains the first dither signal, and in the predetermined time period, the optical waves emitted by other laser devices do not contain the first dither signal.

The optical combiner 502 is adapted to combine the two or more optical waves emitted by the two or more laser devices into one optical signal, and send the optical signal.

The wavelength drift obtaining module 503 is adapted to obtain a wavelength drift of the optical wave to which the first dither signal is added from the optical signal sent by the optical combiner according to the first dither signal, and specifically includes an optical splitter 504, a wave locking device 505 and a weak dither extraction unit 506.

The optical splitter 504 is adapted to extract a proportion of the optical signal from the optical signal output from the optical combiner according to the first dither signal, and input the proportion of the optical signal to the wave locking device. The first dither signal is added to only one of the optical waves contained in the optical signal.

The wave locking device 505 is adapted to obtain a first electric signal and a second electric signal according to the proportion of the optical signal. The wave locking device includes an etalon, and the etalon is a device sensitive to the optical wavelength. The wave locking device receives the optical signal and divides the optical signal into two, the first electric signal is obtained from one optical signal passing through the etalon, and the second electric signal is obtained from the other optical signal not passing through the etalon. The change of the optical signal can be obtained by comparing the first electric signal and the second electric signal.

The weak dither extraction unit 506 is adapted to obtain the wavelength drift of the optical wave to which the first dither signal is added according to the first electric signal and the second electric signal.

The weak dither extraction unit 506 includes an analog filter 507, an A/D converter 509, a digital filter 510 and a wavelength comparison sub-unit 511.

The analog filter 507 is adapted to perform amplification and analog filtering processing on the first electric signal and the second electric signal to eliminate out-of-band noise, so as to respectively obtain an analog signal of the first electric signal and an analog signal of the second electric signal. The analog filter 507 includes a small signal amplification unit 508.

The small signal amplification unit 508 is adapted to amplify weak information output by the wave locking device, so as to facilitate extraction of the dither signal.

The A/D converter 509 is adapted to perform A/D conversion on the analog signal of the first electric signal and the analog signal of the second electric signal to respectively obtain a digital signal of the first electric signal and a digital signal of the second electric signal.

The digital filter 510 is adapted to perform digital filtering on the digital signal of the first electric signal and the digital signal of the second electric signal to respectively obtain a third electric signal containing dither signal information and a fourth electric signal. The digital filter may be realized through programming by a programmable device, and the programmable device includes a FPGA, an ASIC, a CPU, and a DSP. The digital filter may be selected from a finite impulse response filter, an infinite impulse response filter, and a combination thereof. An order of the digital filter may be adjusted through relevant parameters. When the dither signal changes, only a corresponding parameter of the digital filter needs to be changed; when the slope of an edge of a filter window needs to be increased, only the order of the digital filter needs to be added. And a commissioning process thereof may be performed through a JTAG or other interfaces of a used specific programming device.

The wavelength comparison sub-unit 511 is adapted to obtain the wavelength drift of the optical wave to which the first dither signal is added according to the third electric signal and the fourth electric signal. The wavelength comparison sub-unit compares the third electric signal and the fourth electric signal, so that the wavelength drift of the optical wave emitted by the laser device to which the first dither signal is added can be obtained according to a comparison result.

The wavelength locking module 512 is adapted to perform wavelength locking on the optical wave to which the first dither signal is added according to the first dither signal. The wavelength locking module 512 includes a control unit 513 and two or more laser device driver/control circuits 514.

The control unit 513 is adapted to transmit a second dither signal and a control signal to corresponding laser device driver/control circuits according to the wavelength drift of the optical wave.

The control unit generates a corresponding control signal according to the wavelength drift of the optical wave, and transmits the control signal to the laser device driver/control circuit corresponding to the optical wave to which the first dither signal is added. In addition, the control unit continuously generates new dither signals. In the embodiment of the present invention, a dither signal generated by the control unit in a time period after the generation of the first dither signal is called a second dither signal, and the control unit transmits the second dither signal to the laser device driver/control circuit other than the laser device driver/control circuit corresponding to the optical wave to which the first dither signal is added.

Among the two or more laser device driver/control circuits 514, the laser device driver/control circuit 514 corresponding to the control signal is adapted to adjust the wavelength of the optical wave according to the control signal, and the laser device driver/control circuit 514 corresponding to the second dither signal is adapted to mark the optical wave currently under the wavelength adjustment according to the second dither signal, so as to complete the wavelength locking of the optical wave.

The corresponding laser device driver/control circuits respectively receive the second dither signal and the control signal sent by the control unit. The laser device driver/control circuit corresponding to the optical wave to which the first dither signal is added adjusts the wavelength of the optical wave emitted by the corresponding laser device according to the control signal sent by the control unit, so as to complete the wavelength locking; the laser device driver/control circuit corresponding to the optical wave to which the second dither signal is added adds the second dither signal to the optical wave emitted by the corresponding laser device, and marks the locked optical wave. In one time period, the wavelength locking is performed on the optical wave emitted by one of the two or more laser devices; in a next time period, the wavelength locking is performed on the optical wave emitted by another laser device other than the laser device, and so on. Except for an application time period, namely the generation time, other parameters of the first dither signal and the second dither signal are basically the same. The purpose of adding the dither signal to the optical wave is to mark the current optical wave and distinguish the optical wave currently under control; in addition, the wavelength drift of the optical wave is obtained through observing the change of the dither signal, and thereby the wavelength of the optical wave is adjusted, thus completing the wavelength locking.

As for a combination of two or more PIDs/PICs, the wavelength locking may be performed by using the above centralized wave locking and dither extraction apparatus. As shown in FIG. 3, N

PID/PIC devices are combined, and each PID/PIC includes M laser devices, and through the above apparatus, the wavelength locking of M*N optical waves by using one dither signal can be realized by means of time division multiplexing.

The above descriptions are merely specific embodiments of the present invention, but not intended to limit the present invention. Any modification or replacement made by persons skilled in the art without departing from the technical solutions disclosed in the present invention should fall within the scope of the present invention. Therefore, the scope of the present invention is subject to the scope of the claims.

## Claims

1. A method for filtering locking, comprising:
receiving two or more optical waves to which a first dither signal is added by means of time division multiplexing, wherein in a predetermined time period, the first dither signal is on one of the two or more optical waves;
combining the two or more optical waves into one optical signal and sending the optical signal;
obtaining a wavelength drift of the optical wave from the optical signal according to the first dither signal; and
performing wavelength locking on the optical wave according to the wavelength drift of the optical wave.

2. The method for filtering locking according to claim 1, wherein the obtaining the wavelength drift of the optical wave from the optical signal according to the first dither signal comprises:
extracting a proportion of the optical signal from the optical signal according to the first dither signal;
obtaining a first electric signal and a second electric signal according to the proportion of the optical signal; and
performing weak dither extraction on the first electric signal and the second electric signal to obtain the wavelength drift of the optical wave.

3. The method for filtering locking method according to claim 2, wherein the performing the weak dither extraction on the first electric signal and the second electric signal to obtain the wavelength drift of the optical wave comprises:
performing analog filtering processing on the first electric signal and the second electric signal to respectively obtain an analog signal of the first electric signal and an analog signal of the second electric signal;
performing analog/digital (A/D) conversion on the analog signal of the first electric signal and the analog signal of the second electric signal to respectively obtain a digital signal of the first electric signal and a digital signal of the second electric signal;
performing digital filtering on the digital signal of the first electric signal and the digital signal of the second electric signal to respectively obtain a third electric signal containing dither signal information and a fourth electric signal; and
comparing the third electric signal and the fourth electric signal to obtain the wavelength drift of the optical wave.

4. The method for filtering locking according to claim 3, wherein before the performing the analog filtering processing on the first electric signal and the second electric signal to respectively obtain the analog signal of the first electric signal and the analog signal of the second electric signal, the method further comprises:
amplifying the first electric signal and the second electric signal.

5. The method for filtering locking according to claim 1, wherein the performing the wavelength locking on the optical wave according to the wavelength drift of the optical wave comprises:
sending a second dither signal and a control signal by means of time division multiplexing according to the wavelength drift of the optical wave; and
adjusting the wavelength of the optical wave according to the control signal, and marking the optical wave currently under the wavelength adjustment according to the second dither signal, so as to complete the wavelength locking of the optical wave.

6. An apparatus for filtering locking, comprising:
two or more laser devices (501), adapted to receive two or more optical waves to which a first dither signal is added by means of time division multiplexing, wherein in a predetermined time period, the first dither signal is on one of the two or more optical waves;
an optical combiner (502), adapted to combine the two or more optical waves emitted by the two or more laser devices (501) into one optical signal, and send the optical signal;
a wavelength drift obtaining module (503), adapted to obtain a wavelength drift of the optical wave from the optical signal according to the first dither signal; and
a wavelength locking module (512), adapted to perform wavelength locking on the optical wave according to the wavelength drift of the optical wave.

7. The apparatus for filtering locking according to claim 6, wherein the wavelength drift obtaining module (503) comprises:
an optical splitter (504), adapted to extract a proportion of the optical signal from the optical signal output from the optical combiner (502) according to the first dither signal, and input the proportion of the optical signal to a wave locking device (505);
the wave locking device (505), adapted to obtain a first electric signal and a second electric signal according to the proportion of the optical signal; and
a weak dither extraction unit (506), adapted to obtain the wavelength drift of the optical wave according to the first electric signal and the second electric signal.

8. The apparatus for filtering locking according to claim 7, wherein the weak dither extraction unit (506) comprises:
an analog filter (507), adapted to perform analog filtering processing on the first electric signal and the second electric signal to respectively obtain an analog signal of the first electric signal and an analog signal of the second electric signal;
an analog/digital (A/D) converter (509), adapted to perform A/D conversion on the analog signal of the first electric signal and the analog signal of the second electric signal to respectively obtain a digital signal of the first electric signal and a digital signal of the second electric signal;
a digital filter (510), adapted to perform digital filtering on the digital signal of the first electric signal and the digital signal of the second electric signal to respectively obtain a third electric signal containing dither signal information and a fourth electric signal; and
a wavelength comparison sub-unit (511), adapted to compare the third electric signal and the fourth electric signal to obtain the wavelength drift of the optical wave.

9. The apparatus for filtering locking according to claim 8, wherein the analog filter (507) comprises:
a small signal amplification unit (508), adapted to amplify the first electric signal and the second electric signal output by the wave locking device (505).

10. The apparatus for filtering locking according to claim 6, wherein the wavelength locking module (512) comprises:
a control unit (513), adapted to send a second dither signal and a control signal to corresponding laser device driver/control circuits (514) by means of time division multiplexing according to the wavelength drift of the optical wave; and
two or more laser device driver/control circuits (514), wherein the laser device driver/control circuit corresponding to the control signal is adapted to adjust the wavelength of the optical wave according to the control signal, and the laser device driver/control circuit corresponding to the second dither signal is adapted to mark the optical wave currently under the wavelength adjustment according to the second dither signal, so as to complete the wavelength locking of the optical wave.
